# EUROPEAN PATENT APPLICATION

(11) **EP 1 691 246 A2**
(43) Date of publication of application: **16.08.2006**
(21) Application number: 06000509.7
(22) Date of filing: 11.01.2006
(51) Int. Cl.: G05F 1/67

(54) **Power conditioner comprising curve tracer and curve evaluating method for curve tracer**

(30) Priority: 18.01.2005 JP 2005009823
(71) Applicant: OMRON CORPORATION, Kyoto-shi, Kyoto 600-8530 (JP)
(72) Inventor: Toyoura, Nobuyuki c/o Omron corporation, Shimogyo-ku, Kyoto-shi Kyoto 600-8530 (JP); Mabuchi, Masao c/o Omron Corporation, Shimogyo-ku, Kyoto-shi Kyoto 600-8530 (JP)
(74) Representative: Kilian, Helmut

(57) **Abstract**

The present invention is applied to a photovoltaic power generation system 1 comprising a solar battery system 2 provided with a plurality of solar battery modules 6 disposed in series and in parallel, a connection box 3, and a power conditioner 4 for converting a direct-current power PX into an alternate power synchronizing with a frequency (50Hz /60Hz) on a system side (commercial power supply) and an alternate voltage. In a state where the photovoltaic power generation system 1 is actually installed, a DC current IX - direct-current voltage VX curve or a direct-current power PX - direct-current voltage VX curve is displayed on a screen so as to measure if the solar battery system 2 supplied to the power conditioner 4 is in a normal state or an abnormal state.

## Description

### BACKGROUND OF THE INVENTION

### Technical Field

The present invention relates to a power conditioner comprising a curve tracer for judging any abnormality in a solar battery system from a DC current or a curve of the DC current corresponding to a direct-current voltage outputted from the solar battery system and a curve evaluating method for the curve tracer.

### Background Art

In recent years has been commercially available a photovoltaic power generation system adapted to combine a dispersion-type power supply and a commercial power supply in which photovoltaic power generation is adopted so that a power resulting from the photovoltaic power generation is supplied to household appliances (load) and to supply a reverse power flow resulting from any redundant power of the dispersion-type power supply to a system (sell power to a power company), and further, to supply the power from the system side to cover any power shortage when the photovoltaic power generation cannot satisfy a demanded volume of power.

The photovoltaic power generation system comprises a solar battery for converting a photovoltaic energy into an electrical energy, a connection box including diodes and a switcher serving to prevent the output from the solar battery from flowing back to the solar battery side, a power conversion device for converting a direct-current power from the solar battery into an alternate power synchronizing with the commercial power supply, and a protective device for detecting any abnormality in the commercial power supply. The power conversion device and the protective device are combined to constitute a so-called power conditioner.

The solar battery system is adapted in such manner that solar battery modules comprising a plurality of connected solar battery cells are connected in series or in parallel so as to adjust the output to be suitable for an input-voltage range of the power conditioner.

The power conditioner comprises a MPPT (Max Power Point Trucking) function for controlling the power outputted from the solar battery system to be maximized.

As a conventional technology for detecting a disconnection of the solar battery cells is publicly known a solar battery monitoring device of the photovoltaic power generation system as disclosed in Japanese Patent Application Laid-open (JP-A) No. 09-102622 comprising current relays for connecting diodes in a forward direction from a minus side to a plus side of each of the plurality of solar battery modules, the current relays further being connected to the diodes in series to be operated by a by-pass current flowing through the diodes, and an output means for outputting the flow of the by-pass current into the current relays for a predetermined length of time, if any, as a failure of the solar battery module.

Thereby, a position of the failed solar battery module can be identified, and the solar battery array comprising the plurality of solar battery modules can be easily maintained.

Further, as a conventional technology for monitoring any defective solar battery panels is publicly known a solar battery monitoring device as disclosed in Japanese Patent Application Laid-open (JP-A) No. 11-175177 for detecting a power generated by each of the solar battery panels connected in parallel, comparing the respective generatedpowers to a theoretical figure of the power generation and detecting the solar battery module generating the power smaller than the power-generation theoretical figure, if any, as defective.

Thereby, the defective solar battery module can be easily and readily detected.

In the conventional photovoltaic power generation system, the failure of any solar battery module may be overlooked because the power outputted from each solar battery module is changed in accordance with an illuminance even when the disconnection is generated in the cells of the solar battery modules during the operation of the system or the outputted power is reduced in the case where the solar battery modules are placed in shade.

Therefore, there is a time delay before the reduction of the power outputted from the solar battery module is confirmed, which unfavorably increases a length of time when the system is not effectively used. In response to the problem, users have been requesting that the any abnormality in the solar battery system be soon detected and solved.

Further, in the conventional technology, the user is unable to easily confirm whether or not the output of the solar battery system is normal after the photovoltaic power generation system is installed. A manufacturer of the system may be able to make the confirmation after the installation if it is possible to bring a large variable load into the installation site, which is, however, practically difficult.

In the case of the former solar battery monitoring device, the failure of the solar battery module can be detected after the device is installed in a user's house. However, though an open failure of each solar battery module can be detected, the current relays have to be connected in parallel to each of a number of solar battery modules, which disadvantageously increases costs of the solar battery modules because of the too many current relays.

The latter solar battery monitoring device detects the failure by comparing the generated power of each solar battery panel to the power-generation theoretical figure. More specifically, the device detects the abnormality of the solar battery panel by setting the power-generation theoretical figure based on the generated power of the solar power panel of the solar battery in the normal state when the photovoltaic power generation system is installed and consecutively comparing the generated power when the system is operated to the theoretical figure for an hour. Therefore, the generated power of the solar battery panel may be changed and detected as being in the abnormal state because the daylight irradiation (illuminance) is changed during the operation of the system and the generated power of the solar battery panel is compared to the theoretical figure for such a long period of time as an hour.

The present invention was implemented in order to solve the foregoing problems, and a main object thereof is to provide a power conditioner comprising a curve tracer capable of easily monitoring an abnormality of an output of a solar battery system based on a curve of an output characteristic anytime in a state where a photovoltaic power generation system is installed in a user's house.

### DISCLOSURE OF THE INVENTION

In order to solve the foregoing problems, a power conditioner comprising a curve tracer according to the present invention comprises a curve tracing means for measuring a DC current (IX) corresponding to a direct-current voltage (VX) of an external direct-current power supply such as a solar battery and a fuel battery, a DC current (IX) - direct-current voltage (VX) curve, or a direct-current power (PX) - direct-current voltage (VX) curve by operating a direct-current power (PX) from the measured DC current (IX) and the direct-current voltage (VX).

Because the power conditioner in which the curve tracer is incorporated according to the present invention comprises the curve tracing means for measuring the DC currents (IX) corresponding to a plurality of direct-current voltages (VX) of the external direct-current power supply such as the solar battery and the fuel battery, and tracing the DC current (IX) - direct-current voltage (VX) curve, or the direct-current power (PX) - direct-current voltage (VX) curve by operating the direct-current power (PX) from the measured DC current (IX) and direct-current voltage (VX), any abnormality of the external direct-current power supply can be visually confirmed from a distortion of the traced DC current (IX) -direct-current voltage (VX) curve or direct-current power (PX) -direct-current voltage (VX) curve.

The curve tracing means according to the present invention comprises a setting means for setting a set voltage (VS) and a set current (IS) that are variable in the power conditioner, a current measuring means for measuring the DC current (IX) of the external direct-current power supply, a voltage measuring means for measuring the direct-current voltage (VX) of the external direct-current power supply, an operating means for outputting the direct-current power (PX) by multiplying the DC current (IX) measured by the current measuring means and the direct-current voltage (VX) measured by the voltage measuring means by each other, a memorizing means for memorizing the DC current (IX) or the direct-current power (PX) corresponding to the direct-current voltage (VX), and a display means for reading the DC current (IX) or the direct-current power (PX) corresponding to the direct-current voltage (VX) memorized in the memorizing means and displaying a DC current (I) - direct-current voltage (V) curve or a direct-current power (P) - direct-current voltage (V) curve.

Because the curve tracing means according to the present invention comprises the settingmeans for setting the set voltage (VS) and the set current (IS) that are variable in the power conditioner, the current measuring means for measuring the DC current (IX) of the external direct-current power supply, the voltage measuring means for measuring the direct-current voltage (VX) of the external direct-current power supply, the operating means foroutputtingthedirect-currentpower (PX) by multiplying the DC current (IX) measured by the current measuring means and the direct-current voltage (VX) measured by the voltage measuring means by each other, the memorizing means for memorizing the DC current (IX) or the direct-current power (PX) corresponding to the direct-current voltage (VX), and the display means for reading the DC current (IX) or the direct-current power (PX) corresponding to the direct-current voltage (VX) memorized in the memorizing means and displaying the DC current (IX) - direct-current voltage (VX) curve or the direct-current power (PX) - direct-current voltage (VX) curve, the DC current (IX) and the direct-current power (PX) in accordance with the variation of the direct-current voltage (VX) outputted from the external direct-current power supply can be memorized as data, and the DC current (IX) - direct-current voltage (VX) curve or thedirect-currentpower (PX) -direct-currentvoltage (VX) curve can be traced on a screen based on the memorized data.

Further, the setting means according to the present invention is characterized in outputting the variable set voltage (VS) for bi-directionally sweeping the direct-current voltage (VX) outputted from the external direct-current power supply between a minimum voltage (VMIN) and an open-circuit voltage (VOP) .

Because the setting means according to the present invention is adapted to output the variable set voltage (VS) for bi-directionally sweeping the direct-current voltage (VX) outputted from the external direct-current power supply between the minimum voltage (VMIN) and the open-circuit voltage (VOP), when the DC current (IX) - direct-current voltage (VX) curve or the direct-current power (PX) - direct-current voltage (VX) curve that is bi-directionally swept with respect to the variable set voltage (VS) is overlapped, it can be judged that the output of the external power supply is not changed though a sweeping speed is low.

The setting means according to the present invention is characterized in that a variable speed of the set voltage (VS) is sufficiently higher than an energy conversion speed of the external direct-current power supply.

Because the variable speed of the set voltage (VS) is sufficiently higher than the energy conversion speed of the external direct-current power supply in the setting means according to the present invention, the DC current (IX) - direct-current voltage (VX) curve or the direct-current power (PX) - direct-current voltage (VX) curve can be swept in a state where conditions imposed on the external power supply are constant.

Further, the memorizing means according to the present invention is characterized in memorizing a reference DC current (IR) or a reference direct-current power (PR) corresponding to the direct-current voltages (VX) from the minimum voltage (VMIN) to the open-circuit voltage (VOP) of the external direct-current power supply in which a normal operation is guaranteed.

Because the memorizing means according to the present invention memorizes the reference DC current (IR) or the reference direct-current power (PR) corresponding to the direct-current voltages (VX) from the minimum voltage (VMIN) to the open-circuit voltage (VOP) of the external direct-current power supply, the abnormality in the external direct-current power supply at the time can be detected as a result of the data comparison of the actually measured DC current (IX) or direct-current power (PX) to the reference or the comparison of the traced curves.

Further, the display means according to the present invention is characterized in comprising a personal computer.

Because the display means according to the present invention comprises the personal computer, the DC current (IX) or the direct-current power (PX) corresponding to the direct-current voltage (VX) memorized in the memorizing means can be read so that the curve is traced. Further, the reference DC current (IR) or the reference direct-current voltage (VR ) corresponding to the direct-current voltage (VX) from the minimum voltage (VMIN) to the open-circuit voltage (VOP) of the external direct-current power supply at which the normal operation is guaranteed can be inputted so that the reference DC power (PR) is operated and memorized. As a result, a reference curve can also be traced.

Further, the curve tracer according to the present invention is characterized in being applied to the power conditioner of the photovoltaic power generation system.

Because the curve tracer according to the present invention is applied to the power conditioner of the photovoltaic power generation system, a software and a hardware of the power conditioner can constitute the curve tracing means except for the personal computer.

A curve evaluation method for the curve tracer according to the present invention is characterized in that a difference between the data of the DC current (IX) or the direct-current power (PX) corresponding to the direct-current voltage (VX) measured by the curve tracer is obtained, and the solar battery is judged to be in the abnormal state based on the judgment that there are at least two peaks in the curve in the presence of at least two points at which a value of the difference is changed from plus to minus.

Because the difference between the data of the DC current (IX) or the direct-current power (PX) corresponding to the direct-current voltage (VX) measured by the curve tracer is obtained, and the solar battery is judged to be in the abnormal state based on the judgment that there are at least two peaks in the curve in the presence of at least two points at which the difference value is changed from plus to minus in the curve evaluation method for the curve tracer according to the present invention, the abnormality of the solar battery can be automatically judged from the data on the personal computer, or can be visually confirmed from the traced curve.

Further, the curve evaluation method for the curve tracer according to the present invention is characterized in that a curve traced by the curve tracer during the operation and a reference curve generated and memorized by the curve tracer using the external direct-current power supply of the solar battery system in which the normal operation is previously guaranteed are compared to each other so that the abnormality of the solar battery is detected from patterns of the curves.

Because the curve traced by the curve tracer during the operation and the reference curve generated and memorized by the curve tracer using the external direct-current power supply of the solar battery system in which the normal operation is previously guaranteed are compared to each other so that the solar battery is judged to be in the abnormal state from the patterns of the curves in the curve evaluation method for the curve tracer according to the present invention, the abnormality of the solar battery system can be detected from a difference in shapes, current values, voltage values and numbers of inflections between the reference curve and the traced curve.

The power conditioner comprising the curve tracer according to the present invention comprises the curve tracing means for measuring the DC currents (IX) corresponding to the plurality of direct-current voltages (VX) of the external direct-current power supply such as the solar battery and the fuel battery, operating the direct-current power (PX) from the DC current (IX) - direct-current voltage (VX) curve or the measured DC current (IX) and direct-current voltage (VX) and tracing the direct-current power (PX) - direct-current voltage (VX) curve. Therefore, the abnormality of the external direct-current power supply can be visually confirmed from the distortion of the tracedDC current (IX) - direct-current voltage (VX) curve or direct-current power (PX) - direct-current voltage (VX) curve. As a result, the users can enjoy an improved convenience and user-friendliness.

Because the difference between the data of the DC current (IX) or the direct-current power (PX) corresponding to the direct-current voltage (VX) measured by the curve tracer is obtained, and the solar battery is judged to be in the abnormal state based on the judgment that there are at least two peaks in the curve in the presence of at least two points at which the difference value is changed from plus to minus in the curve evaluation method for the curve tracer according to the present invention, the abnormality can be automatically detected from the data on the personal computer or visually confirmed from the traced curve. As a result, the convenience and the user-friendliness can be improved.

### BRIEF DESCRIPTION OF THE DRAWINGS

Fig. 1 shows the application of a power conditioner comprising a curve tracer according to the present invention to a photovoltaic power generation system according to an embodiment of the present invention.
Fig. 2 shows a block diagram of an essential part of the curve tracer according to the embodiment of the present invention.
Fig. 3 shows a graph of a power curve F and a current curve G in a normal operation according to the embodiment traced by the curve tracer according to the present invention.
Fig. 4 shows a sweep illustration of a power curve F and a current curve G according to the embodiment of the present invention.
Fig. 5 shows a plot diagram according to the embodiment illustrating a direct-current reference power PR - direct-current voltage VX curve (power curve F) traced by the curve tracer according to the present invention.
Fig. 6 shows a graph of the power curve F in an abnormal operation according to the embodiment traced by the curve tracer according to the present invention.
Fig. 7 shows a block diagram illustrating a constitution according to another embodiment of the present invention in which the curve tracer according to the present invention is installed in the power conditioner.

### DESCRIPTION OF THE PREFERRED EMBODIMENTS

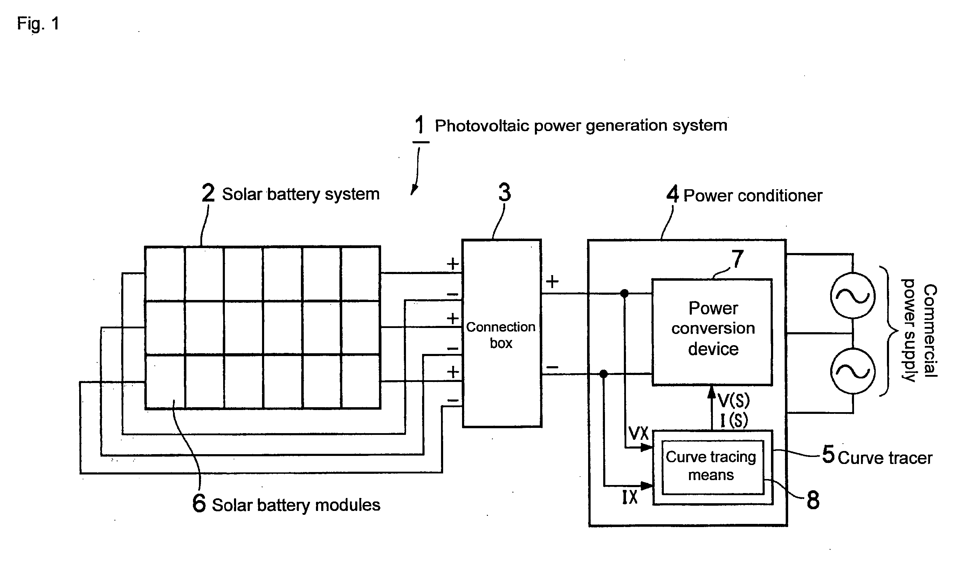

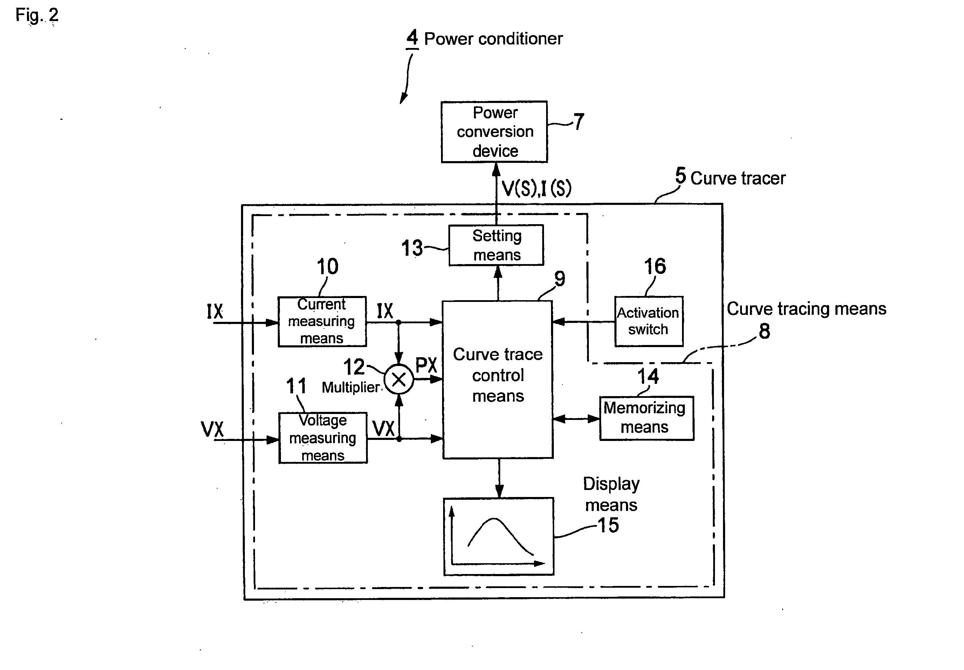

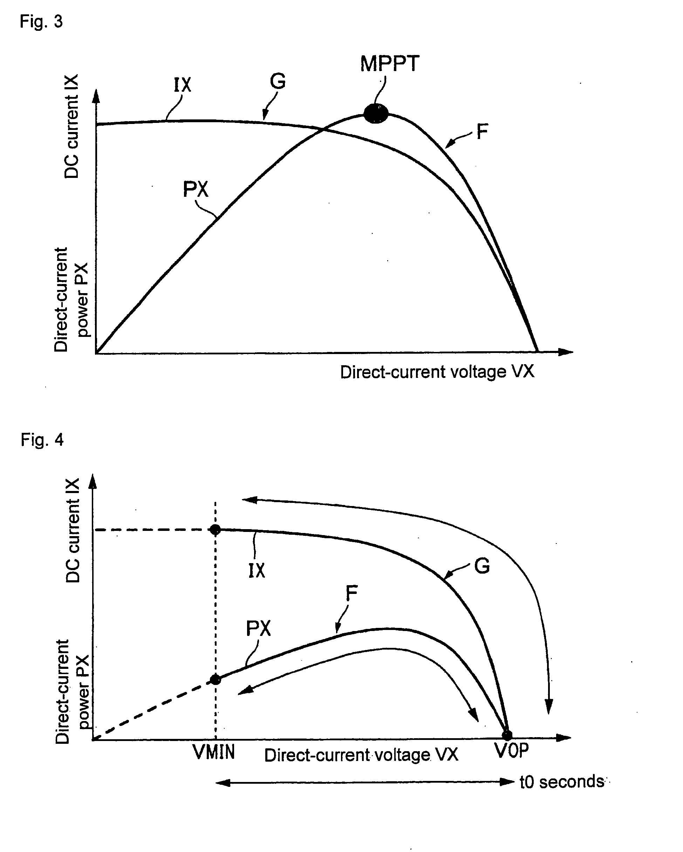

Hereinafter, preferred embodiments of the present invention are described referring to the drawings. In the embodiments below is described a case where a power conditioner comprising a curve tracer is applied to a photovoltaic power generation system. Fig. 1 shows the application of a power conditioner comprising a curve tracer according to the present invention to a photovoltaic power generation system according to an embodiment of the present invention.

In Fig. 1, a photovoltaic power generation system 1 comprises a solar batter system 2 provided with a plurality of solar battery modules 6 disposed in series and in parallel, a connection box 3 for collectively outputting a plurality of pairs of plus and minus direct-current outputs from the solar battery system 2 as a pair of direct-current powers, and a power conditioner 4 including a power conversion device 7 for converting the pair of direct-current powers supplied from the connection box 3 into an alternate power synchronizing with a frequency (50Hz/60Hz) on the system side (commercial power supply) and an alternate voltage and a curve tracer 5 for displaying a DC current IX - direct-current voltage VX curve or a direct-current power PX - direct-current voltage VX curve on a screen in order to detect if the supplied solar battery system 2 is normally or abnormally operated in a state where the photovoltaic power generation system 1 is actually installed.

The curve tracer 5 comprises a curve tracing means 8 for supplying a set voltage V (S) or a set current I (S) as an instructed value, measuring the DC currents IX corresponding to a plurality of direct-current voltages VX of the solar battery system 2 from the operation of the power conversion device 7, operating the direct-current power PX from the DC current IX - direct-current voltage VX curve or the measured DC current IX and direct-current voltage VX and tracing the direct-current power PX - direct-current voltage VX curve.

In the solar battery system 2, though an illuminance of sunlight is constant, when a disconnection is generated in the solar battery modules 6 or the cells constituting the solar battery modules 6, or when a part of sunlight entering the solar battery modules 6 is interrupted in the presence of bird feces or because the modules are placed in shade, the output of the generated power is reduced, which consequently generates a distortion in the DC current IX - direct-current voltage VX curve or the direct-current power PX - direct-current voltage VX curve.

Therefore, when the DC current IX - direct-current voltage VX curve or the direct-current power PX - direct-current voltage VX curve traced by the curve tracer 5 is visually observed on the screen, it can be judged if the solar battery system 2 is normally operated or abnormally operated in a state where the photovoltaic power generation system 1 is installed.

Fig. 2 shows a block diagram of an essential part of the curve tracer according to the embodiment of the present invention. In Fig. 2, the curve tracing means 8, an activation switch 16, a power-supply circuit not shown and the like constitute the curve tracer 5.

A software program constitutes the curve tracing means 8 with a microprocessor as a basic component. The curve tracing means 8 comprises a curve trace control means 9, a current measuring means 10, a voltage measuring means 11, a multiplier 12, a setting means 13, a memorizing means 14, and a display means 15.

The curve trace control means 9 controls an entire operation and a sequence operation of the curve tracing means 8.

The curve trace control means 9 further controls the memorization of the DC current IX measured by the current measuring means 10 in the memorizing means 14.

The curve trace control means 9 further controls the memorization of the direct-current voltage VX measured by the voltage measuring means 11 in the memorizing means 14.

The curve trace control means 9 further controls the memorization of the direct-current power PX (= DC current IX x direct-current voltage VX) operated by the multiplier 12 constituting the operating means in the memorizing means 14.

Further, the curve trace control means 9 controls reading of the instructed value of the set voltage V (S) or the set current I (S) stored in the memorizing means 14 when an activation signal is supplied via the activation switch 16, and the supply from the setting means 13 to the power conversion device 7.

Further, the curve trace control means 9 controls reading of the data of the DC current IX corresponding to the direct-current voltage VX or the data of the direct-current power PX corresponding to the direct-current voltage VX memorized in the memorizing means 14, conversion of the read data into an image data to thereby supply the image data to the display means 15, and tracing of the DC current (IX) - direct-current voltage (VX) curve or the direct-current power (PX) - direct-current voltage (VX) curve on the screen of the display means 15.

The current measuring means 10 measures the DC current IX applied to the power conditioner 4 from the solar battery system 2, and supplies the measured DC current IX to the multiplier 12 and the curve trace control means 9.

The voltage measuring means 11 measures the direct-current voltage VX inputted to the power conditioner 4 from the solar battery system 2 and supplies the measured direct-current voltage VX to the multiplier 12 and the curve trace control means 9.

The multiplier 12 calculates a product of the DC current IX supplied from the current measuring means 10 and the direct-current voltage VX supplied from the voltage measuring means 11 (= IX x VX) and supplies the direct-current power PX (= IX x VX) supplied from the solar battery system 2 to the curve trace control means 9.

The setting means 13 supplies the instructed value of the set voltage V (S) or the set voltage I (S) supplied from the curve trace control means 9 to the power conversion device 7 and thereby changes the direct-current voltage VX supplied from the solar battery system 2 so that the DC current IX corresponding to the direct-current voltage VX is applied.

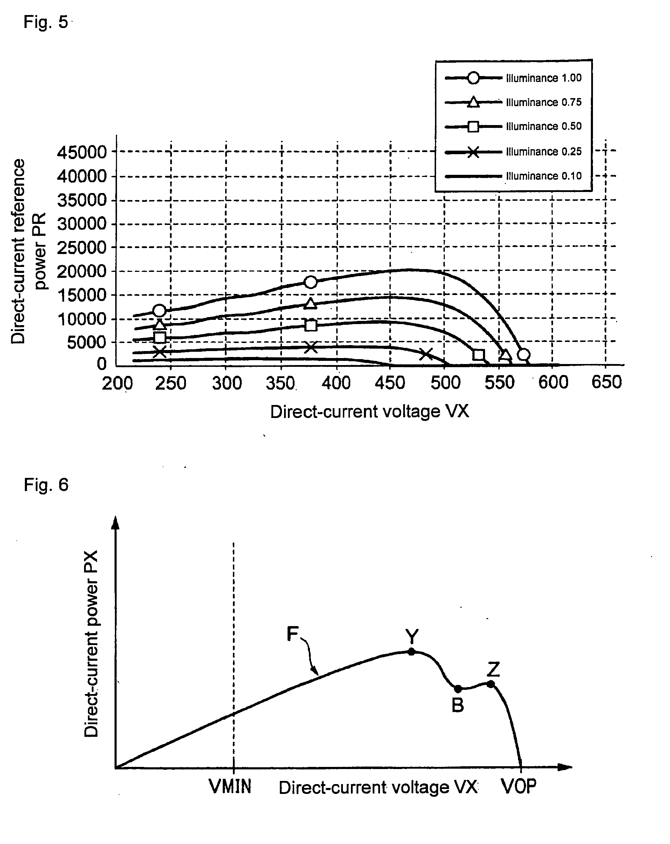

Further, the setting means 13 changes the instructed value and outputs the variable set voltage V (S) for bi-directionally sweeping the direct-current voltage (VX) between a minimum voltage (VMIN) and an open-circuit voltage (VOP) as shown in Fig. 4.

Further, as shown in Fig. 4, the setting means 13 sets a variable speed of the instructed value of the set voltage V (S) or the set current I (S) for sweeping the direct-current voltage VX in two directions, that are from the minimum voltage VMIN to the open-circuit voltage VOP and from the open-circuit voltage VOP to the minimum voltage VMIN, in such manner that the variable speed is increased (t0 seconds in one direction).

The minimum voltage VMIN represents a minimum operation voltage of the photovoltaic power generation system 1, while the open-circuit voltage VOP represents an open-circuit voltage when the set current I (S) is set to 0.

Thereby, when the DC current (IX) - direct-current voltage (VX) curve (current curve G) or the direct-current power (PX) - direct-current voltage (VX) curve (power curve F) that is bi-directionally swept with respect to the variable set voltage V(S) is overlapped, it can be judged that the output of the solar battery system 2 is not changed though a sweeping speed is low. On the contrary, when the DC current (IX) - direct-current voltage (VX) curve (current curve G) or the direct-current power (PX) - direct-current voltage (VX) curve (power curve F) is not overlapped, it can be judged that the output of the solar battery system 2 is changed during the bi-directional sweep.

When the sweeping speed (variable speed: t0 in one direction) is increased, measuring conditions (influences from change of illuminance, shade and the like) can be fixed so that the DC current (IX) - direct-current voltage (VX) curve (current curve G) or the direct-current power (PX) - direct-current voltage (VX) curve (power curve F) is not changed in reciprocation and can be overlapped.

Thus, the setting means 13 according to the present invention outputs the variable set voltage V (S) for bi-directionally sweeping the direct-current voltage VX outputted from the external direct-current power supply (solar battery system 2) between the minimum voltage VMIN and the open-circuit voltage VOP. Therefore, when the DC current (IX) - direct-current voltage (VX) curve (current curve G) or the direct-current power (PX) - direct-current voltage (VX) curve (power curve F) that is bi-directionally swept with respect to the variable set voltage V (S) is overlapped, it can be determined that the output of the external power supply is not changed though the sweeping speed is low. Further, if the external power supply is in the normal state or the abnormal state can be judged from the visual observation of the presence / absence of the distortion in the curve.

Further, the setting means 13 according to the present invention is capable of sweeping the DC current (IX) - direct-current voltage (VX) curve (current curve G) or the direct-current power (PX) - direct-current voltage (VX) curve (power curve F) in the state where the conditions imposed on the external power supply (solar battery system 2) are constant because the variable speed of the set voltage V (S) is high and thereby accurately tracing the curve with the fixed measuring conditions.

The memorizing means 14 stores an operation program and a sequence program of the curve tracing means 8.

Further, the memorizing means 14 stores the instructed value of the set voltage V (S) and the set current I (S) = 0, and supplies the instructed value of the set voltage V (S) and the set current I (S) = 0 to the setting means 13 under the control of the curve trace control means 9.

Further, the memorizing means 14 stores the data of the DC current IX supplied from the current measuring means 10 and the data of the direct-current power PX supplied from the multiplier 12 corresponding to the data of the direct-current voltage VX supplied from the voltage measuring means 11 (minimum voltage VMIN to open-circuit voltage VOP).

Further, the memorizing means 14 stores the data of a direct-current reference current IR and the data of a direct-current reference power PR corresponding to the direct-current voltage VX in the normal state under a plurality of illuminance conditions of the solar battery system 2.

The display means 15 comprises a display device and the like, and traces the data of the DC current IX or the direct-current power PX corresponding to the data of the direct-current voltage VX (from minimum voltage VMIN to open-circuit voltage VOP) stored in the memorizing means 14 using the DC current (IX) - direct-current voltage (VX) curve (current curve G) or the direct-current power (PX) - direct-current voltage (VX) curve (power curve F) under the control of the curve trace control means 9 and displays the tracing result.

Further, the display means 15 traces the data of the direct-current reference current IR or the data of the direct-current reference power PR corresponding to the data of the direct-current voltage VX (from minimum voltage VMIN to open-circuit voltage VOP) stored in the memorizing means 14 using the direct-current reference current IR - direct-current voltage (VX) curve (current curve G) or the direct-current reference power PR - direct-current voltage (VX) curve (power curve F) under the control of the curve trace control means 9 and displays the tracing result. When the direct-current reference power PR - direct-current voltage (VX) curve (power curve F) and the measured direct-current power PX - direct-current voltage VX curve (power curve F) are displayed on the same screen to be compared to each other, if the measured direct-current power PX - direct-current voltage VX curve (power curve F) is normal or abnormal can be instantly visually confirmed.

The display means 15 comprising the personal computer can utilize various functions such as display, data input, data memorization, operation and the like.

Fig. 5 shows a plot diagram according to the embodiment illustrating the direct-current reference power PR - direct-current voltage VX curve (power curve F) traced by the curve tracer according to the present invention. In Fig. 5, the direct-current reference power PR - direct-current voltage VX curve (power curve F) is obtained by normalizing the illuminance of the sunlight irradiating on the solar battery system 2 and plotting and tracing the direct-current reference power PR - direct-current voltage VX curve (power curve F) from the maximum illuminance of 1.00 down to the illuminance of 0.10.

As the illuminance is reduced, the level of the direct-current reference power PR is reduced. However, the direct-current reference power PR - direct-current voltage VS curve (power curve F) shows a smooth waveform in which no distortion is generated because any abnormality is not detected in the solar battery system 2.

Thus, the displaymeans 15 comprising the personal computer can read the DC current IX or the direct-current power PX corresponding to the direct-current voltage VX memorized in the memorizing means 14 and thereby trace the curve (current curve G or power curve F). The display means 15 further inputs the reference DC current IR or the reference direct-current voltage VR, and operates and memorizes the reference direct-current power PR to thereby trace the reference curve (current curve G or power curve F). As a result, the extensibility of the device can be improved.

Further, the memorizing means 14 according to the present embodiment, which memorizes the reference DC current IR or the reference direct-current power PR corresponding to the direct-current voltages VX from the minimum voltage VMIN to the open-circuit voltage VOP of the external direct-current power supply (solar battery system 2), can compare the actually measured DC current IX or direct-current power PX to the reference or compare the traced curves to thereby detect the abnormality of the current external direct-current power supply at the time. As a result, if the external direct-current power supply is in the normal state or the abnormal state can be accurately identified.

Fig. 3 shows a graph of the power curve F and the current curve G in the normal operation according to the embodiment traced by the curve tracer according to the present invention. In Fig. 3, in the absence of any abnormality in the solar battery system 2, the power curve F (direct-current power PX - direct-current voltage VX) ultimately reaches a maximum power (MPPT) as the direct-current power PX shows a smooth increase in response to the increase of the direct-current voltage VX, and then smoothly starts to decrease.

In the current curve G (DC current IX - direct-current voltage VX), the DC current IX decreases along a smooth curve in response to the increase of the direct-current voltage VX.

Fig. 6 shows a graph of the power curve F in the abnormal operation according to the embodiment traced by the curve tracer according to the present invention. In Fig. 6, the waveform distortion is generated in the power curve F (direct-current power PX - direct-current voltage VX) between a point Y and a point Z.

The waveform distortion between the point Y and the point Z includes a change from a plus slope to a minus slop at the point Y, a change from the minus slope to the plus slope at the point B, and a change from the plus slope to the minus slope at the point Z.

The foregoing fact means that three inflection points are generated by the waveform distortion at the points Y, B and Z, which is different to Fig. 3 showing the normal waveform in which an inflection point is generated (corresponding to point Y).

Further, in the waveform distortion, the level change of the direct-current power PX between the points Y and B and the level change of the direct-current power PX between the points B and Z are larger than the level change of the direct-current power PX in the normal waveform shown in Fig. 3.

Therefore, when the power curves F shown in Figs. 3 and 6 are traced on the same screen and compared to each other, it can be instantly visually confirmed if the solar battery system 2 is in the normal state or the abnormal state.

Further, the data of the direct-current power PX corresponding to each direct-current voltage VX of the power curve F shown in Fig. 3 and the data of the direct-current power PX corresponding to each direct-current voltage VX of the power curve F shown in Fig. 6 are stored in the memorizing means 14 and the display means 15 comprising the personal computer. Therefore, it can be automatically judged if the solar battery system 2 is in the normal state or the abnormal state from the data comparison, operation of the waveform slopes or operation of the inflection points.

As described, the curve tracing means 8 according to the present invention comprises the setting means 13 for setting the variable set voltage V (S) and set current (IS) in the power conditioner 4, the current measuring means 10 for measuring the DC current IX of the external direct-current power supply (solar battery system 2), the voltage measuring means 11 for measuring the direct-current voltage VX of the external direct-current power supply, the operating means 12 for multiplying the DC current IX measured by the current measuring means 10 and the direct-current voltage VX measured by the voltage measuring means 11 with each other and outputting the direct-current power PX, the memorizing means 14 for memorizing the DC current IX or the direct-current power PX corresponding to the direct-current voltage VX, and the display means 15 for reading the DC current IX or the direct-current power PX corresponding to the direct-current voltage VX memorized in the memorizing means 14 and displaying the DC current IX - direct-current voltage VX curve or the direct-current power PX -direct-current voltage VX curve. Therefore, the DC current IX and the direct-current power PX corresponding to the variation of the direct-current voltage VX outputted from the external direct-current power supply can be memorized as the data, and the DC current IX - direct-current voltage VX curve and the direct-current power PX - direct-current voltage VX curve can be traced on the screen based on the memorized data. As a result, if the external direct-current power supply is in the normal state or the abnormal state can be instantly visually confirmed.

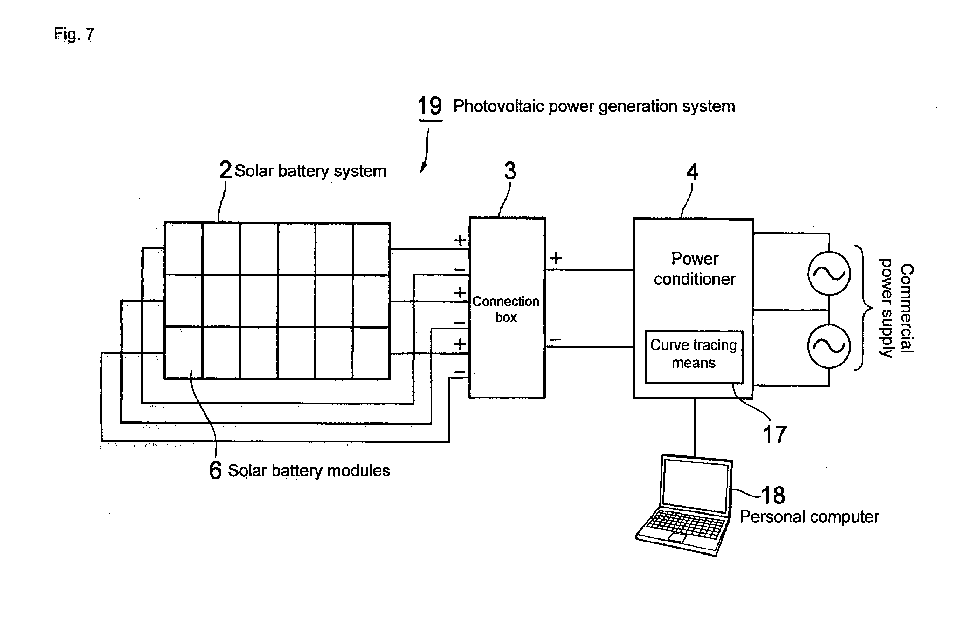

Fig. 7 shows a block diagram illustrating a constitution according to another embodiment of the present invention in which the curve tracer according to the present invention is installed in the power conditioner. In Fig. 7, a curve tracing means 17, which is the curve tracing means 8 shown in Fig. 2, from which the display means 15 is removed, is installed in the power conditioner 4 of the photovoltaic power generation system 19, and a personal computer 18 constituting the display means 15 is provided outside.

The curve trace control means 9, current measuring means 10, voltage measuring means 11, multiplier 12, setting means 13 and memorizing means 14 shown in Fig. 2, which constitutes the curve tracing means 17, are integrally incorporated in the control circuit comprising the microprocessor and software program for controlling and driving the power conversion device 7.

Because the power conditioner comprising the curve tracer according to the present invention is applied to the power conditioner 4 of the photovoltaic power generation system 19 as described, the software and hardware of the power conditioner 4 can constitute the curve tracing means 17 from which the personal computer 18 is removed. As a result, the curve tracing means 17 can be realized with a minimized cost increase without additionally providing any new hardware.

In describing the power conditioner 4 in which the curve tracer according to the present embodiment is incorporated, the power generation system in which the solar battery system 2 is used as the external direct-current power supply is mentioned. However, the power generation system in which the fuel battery is used can also be adopted.

As described, the power conditioner 4 in which the curve tracer according to the present invention is incorporated comprises the curve tracing means 8 for measuring the DC currents IX corresponding to the plurality of direct-current voltages (VX) of the external direct-current power supply such as the solar battery and the fuel battery, operating the direct-current power PX from the DC current IX - direct-current voltage VX curve or the measured DC current IX and direct-current voltage VX and tracing the direct-current power PX - direct-current voltage VX curve. Accordingly, the abnormality of the external direct-current power supply can be visually confirmed from the distortion of the traced DC current IX - direct-current voltage VX curve or direct-current power PX - direct-current voltage VX curve, which improves the convenience and user friendliness.

Next is described a curve evaluation method for a curve tracer for judging the abnormality of the solar battery system. As described, the abnormality of the solar battery system 2 can be instantly visually confirmed from the distortion of the direct-current power PX - direct-current voltage VX curve (power curve F) traced by the curve tracer 5 shown in Fig. 6. However, the abnormality can be automatically judged from the data of the direct-current power PX - direct-current voltage VX curve (power curve F) stored in the memorizing means 14.

In a first method for judging the abnormality, a difference ΔP between the data of the DC current (IX) or the direct-current power (PX) corresponding to the measured direct-current voltage (VX) is obtained, and the abnormality of the solar battery system 2 is detected and notified based on the judgment that there are at least two peaks in the direct-current power PX - direct-current voltage VX curve (power curve F) in the presence of at least two points at which the difference ΔP is changed from plus (+) to minus (-) (for example, points Y and Z shown in Fig. 6).

Further, the number of the inflection points shown in Fig. 6 is counted, and the abnormality of the solar battery system 2 is automatically judged from three inflection points detected in the curve because the normally operated solar battery system 2 only generates one inflection point.

Further, the difference ΔP between the data of the DC current (IX) or the direct-current power (PX) is obtained, and the abnormality of the solar battery system 2 is detected and notified when there is at least one point at which the difference ΔP is changed from minus (-) to plus (+) (for example, point B shown in Fig. 6).

In the curve evaluation method for the curve tracer according to the present invention, the difference between the data of the DC current IX or the direct-current power PX corresponding to the direct-current voltage (VX) measured by the curve tracer 5 is obtained, and the abnormality of the solar battery system 2 is detected based on the judgment that there are at least two peaks in the curve in the presence of at least two points at which the difference value is changed from plus to minus. Therefore, the abnormality can be automatically judged from the data on the personal computer 18 or can be visually confirmed based on the traced curve, which improves the convenience and user friendliness.

In a second method for judging the abnormality, the curve actually traced by the curve tracer 5 (direct-current power PX - direct-current voltage VX curve) and the reference curve previously memorized (direct-current reference power PR - direct-current reference voltage VR) are compared to each other so that the abnormality of the solar battery system 2 is detected from a difference between the two curve patterns.

The abnormality may be judged from the visual confirmation or may be automatically judged through data comparison / operation.

As described, in the curve evaluation method for the curve tracer according to the present invention, the curve traced by the curve tracer 5 (direct-current power PX - direct-current voltage VX curve) and the reference curve previously memorized (direct-current reference power PR - direct-current voltage VX curve) are compared to each other so that the abnormality of the solar battery is detected from the difference between the two curve patterns. Therefore, the abnormality of the solar battery system can be detected from a difference in shapes, current values and voltage values, and number of inflection points of the reference curve and the traced curve, which emphasizes the improved convenience and user friendliness.

The power conditioner in which the curve tracer according to the present invention is incorporated is capable of easily monitoring the abnormality in the output of the solar battery system from the curve of the output characteristic anytime in the state where the photovoltaic power generation system is installed in the user's house, and can be applied to the power generation system in which the solar batter, fuel battery or the like is used as the external direct-current power supply.

## Claims

1. A power conditioner (4) provided with a curve tracer (5) comprising a curve tracing means (8,17) for measuring a DC current (IX) corresponding to a direct-current voltage (VX) of an external direct-current power supply (2) such as a solar battery and a fuel battery, and tracing a DC current (IX) - direct-current voltage (VX) curve, or a direct-current power (PX) - direct-current voltage (VX) curve by operating a direct-current power (PX) from the measured DC current (IX) and the direct-current voltage (VX).

2. The power conditioner (4) provided with the curve tracer (5) as claimed in Claim 1, wherein said curve tracing means (8, 17) comprises:
a setting means (13) for setting a set voltage (VS) and a set current (IS) that are variable in the power conditioner (4) ;
a current measuring means (10) for measuring the DC current (IX) of said external direct-current power supply (2);
a voltage measuring means (11) for measuring the direct-current voltage (VX) of said external direct-current power supply (2);
an operating means (12) for outputting the direct-current power (PX) by multiplying the DC current (IX) measured by said current measuring means (10) and the direct-current voltage (VX) measured by said voltage measuring means (11) by each other;
a memorizing means (14) for memorizing the DC current (IX) or the direct-current power (PX) corresponding to the direct-current voltage (VX); and
a display means (15) for reading the DC current (IX) or the direct-current power (PX) corresponding to the direct-current voltage (VX) memorized in said memorizing means (14) and displaying the DC current (IX) - direct-current voltage (VX) curve or the direct-current power (PX) - direct-current voltage (VX) curve.

3. The power conditioner (4) provided with the curve tracer (5) as claimed in Claim 2, wherein said setting means (13) outputs the variable set voltage (VS) for bi-directionally sweeping the direct-current voltage (VX) outputted from said external direct-current power supply (2) between a minimum voltage (VMIN) and an open-circuit voltage (VOP).

4. The power conditioner (4) provided with the curve tracer (5) as claimed in Claim 2 or 3, wherein a variable speed of the set voltage (VS) is sufficiently higher than an energy conversion speed of said external direct-current power supply (2) in said setting means (13).

5. The power conditioner (4) provided with the curve tracer (5) as claimed in Claim 2, wherein said memorizing means (14) memorizes a reference DC current (IR) or a reference direct-current power (PR) corresponding to the direct-current voltages (VX) from a minimum voltage (VMIN) to an open-circuit voltage (VOP) of said external direct-current power supply (2) in which a normal operation is guaranteed.

6. The power conditioner (4) provided with the curve tracer (5) as claimed in Claim 2, wherein said display means (15) comprises a personal computer.

7. The power conditioner (4) provided with the curve tracer (5) as claimed in any of Claims 1 through 6, wherein said curve tracer (5) is applied to a power conditioner (4) of a photovoltaic power generation system (1, 19).

8. A curve evaluation method for a curve tracer (5) for evaluating a curve generated by the curve tracer (5) incorporated in the power conditioner (4) as claimed in any of Claims 1 through 7, wherein a difference between data of the DC current (IX) or the direct-current power (PX) corresponding to the direct-current voltage (VX) measured by the curve tracer (5) is obtained, and a solar battery (2) is judged to be in an abnormal state based on the judgment that there are at least two peaks in the curve in the presence of at least two points at which a value of the difference is changed from plus to minus.

9. The curve evaluation method for the curve tracer (5) as claimed in Claim 8, wherein a reference curve is previously generated and memorized by the curve tracer (5) using said external direct-current power supply (2) in which a normal operation is guaranteed in advance, and a curve traced by the curve tracer (5) during the operation and said reference curve previously memorized are compared to each other so that the abnormality of the solar battery (2) is detected from patterns of the curves.
